# EUROPÄISCHE PATENTSCHRIFT

(11) **EP 2 297 797 B1**
(45) Veröffentlichungstag und Bekanntmachung des Hinweises auf die Patenterteilung: **19.09.2012**
(21) Anmeldenummer: 09765846.2
(22) Anmeldetag: 16.06.2009
(51) Int. Cl.: H01L 41/047, H01L 41/083, H01L 41/22

(54) **PIEZOELEKTRISCHES BAUELEMENT UND VERFAHREN ZUR HERSTELLUNG EINES ELEKTRISCHEN KONTAKTES**
PIEZOELECTRIC COMPONENT AND METHOD FOR THE MANUFACTURE OF AN ELECTRIC CONTACT
COMPOSANT PIÉZOÉLECTRIQUE ET PROCÉDÉ DE FABRICATION D'UN CONTACT ÉLECTRIQUE

(30) Priorität: 19.06.2008 DE 102008029185
(43) Veröffentlichungstag der Anmeldung: 23.03.2011
(73) Patentinhaber: Epcos AG, 81669 München (DE)
(72) Erfinder: HOERMANN, Rainer, A-8501 Lieboch (AT); GOEBEL, Thomas, A-8530 Deutschlandsberg (AT); FEIEL, Gernot, A-8501 Lieboch (AT); PECINA, Axel, A-8543 St. Martin (AT)
(74) Vertreter: Epping - Hermann - Fischer
(86) Internationale Anmeldenummer: PCT/EP2009/057482
(87) Internationale Veröffentlichungsnummer: WO 2009/153266

(56) Entgegenhaltungen:
- EP-A- 1 006 596
- DE-A1- 10 121 270
- DE-A1-102006 020 553
- FR-A- 2 900 514

## Beschreibung

Die Erfindung betrifft ein piezoelektrisches Bauelement sowie ein Verfahren zur Herstellung eines Kontaktes, insbesondere auf einem piezoelektrischen Bauelement.

Piezoelektrische Bauelemente sind beispielsweise aus der Druckschrift US 6,346,764 B1 bekannt. Weitere Bauelemente sind aus DE 10 2006 020 553 A1, FR 2 900 514 und EP 1 006 596 A2 bekannt.

Derartige piezoelektrische Bauelemente kommen in einer Vielzahl von Anwendungen zum Einsatz. Eine typische Anwendung sind Aktoren, bei denen ein piezoelektrisches Bauelement durch eine Steuerspannung zu Schwingungen, beispielsweise zu Biege- oder Streckschwingungen, angeregt wird. Eine natürliche Resonanzfrequenz des piezoelektrischen Bauelementes ergibt sich dabei aus den geometrischen Abmessungen des Bauelementes in Verbindung mit seinen elastischen Eigenschaften. Diese charakterisieren eine Antwort des piezoelektrischen Bauelementes auf eine dem Bauelement zugeführte elektrische Anregung.

In einer typischen Anwendung werden ein oder mehrere piezoelektrische Bauelemente als Aktor oder Aktuator verwendet, um damit einen piezoelektrischen Motor zu realisieren. Durch eine elektrische Anregung, das heißt die Ausbildung eines elektrischen Wechselfeldes wird das piezoelektrische Bauelement zu Schwingungen angeregt und überträgt diese auf ein mit ihm gekoppeltes Element. Dadurch lässt sich beispielsweise ein Gewinde eine einem Motor in eine axiale Rotation versetzen und so bewegen.

Oftmals sind die mit dem piezoelektrischen Bauelement mechanisch verbundenen Elemente zur Bildung eines Aktuators elektrisch leitend. Dadurch ergeben sich besondere Herausforderungen an eine mechanische Befestigung des Bauelementes. So sollte die Montageseite des Bauelementes elektrisch isoliert von der Kontaktierung der Elektroden innerhalb des piezoelektrischen Bauelementes sein, um einen Kurzschluss zwischen verschiedenen piezoelektrischen Bauelementen auf der zu realisierenden Konstruktion zu vermeiden. Andererseits sollen die einzelnen Elektroden innerhalb des piezoelektrischen Bauelementes ohne großen Widerstand kontaktierbar sein, um Leistungsverluste zu minimieren.

Es besteht somit das Bedürfnis, ein piezoelektrisches Bauelement anzugeben, bei dem eine ausreichend gute Kontaktierung gewährleistet ist. Weiterhin soll ein Verfahren zur Herstellung eines elektrischen Kontaktes, insbesondere auf einem piezoelektrischen Bauelement, angegeben werden.

Diesem Bedürfnis wird durch die Gegenstände der unabhängigen Patentansprüche 1 und 11 Rechnung getragen. Weiterbildungen beziehungsweise Ausgestaltungen sind Gegenstand der Unteransprüche.

Bislang erfolgt eine Kontaktierung eines piezoelektrischen Bauelementes durch einen so genannten Tauchprozess. Bei diesem wird das Bauelement mit einer Metallschicht benetzt und so der Kontakt ausgebildet. Bei dem Verfahren erfolgt jedoch eine Benetzung beziehungsweise Metallisierung aller Seiten des Bauelementes. Sofern einige Bereiche, beispielsweise Seitenflächen des piezoelektrischen Bauelementes, nicht metallisiert werden sollen, sind aufwändige Maßnahmen zur Verhinderung einer ungewollten Metallisierung notwendig.

Die Erfindung schlägt nun ein piezoelektrisches Bauelement vor, welches einen elektromechanischen Wandler umfasst wie durch Anspruch 1 definiert. Dieser weist wenigstens zwei erste Elektroden und zumindest eine zweite Elektrode auf, welche zwischen den wenigstens zwei ersten Elektroden angeordnet und durch ein piezoelektrisches Material von ihnen beabstandet ist. Weiterhin enthält der Wandler eine erste Hauptseite, eine der ersten Hauptseite gegenüberliegende zweite Hauptseite sowie eine erste Längsseite. Das piezoelektrische Bauelement zeichnet sich weiterhin aus durch eine zusammenhängende Metallisierungsschicht auf einem ersten Teilbereich der ersten Hauptseite und auf einem dem ersten Teilbereich der ersten Hauptseite benachbarten Teilbereich der Längsseite. Der Teilbereich der Längsseite weist hierbei einen ausreichend isolierenden Abstand von einer der zweiten Hauptseite zugewandten Seitenkante auf. Weiterhin kontaktiert dieser Teilbereich elektrisch die wenigstens zwei Elektroden.

Erfindungsgemäß wird somit ein entlang der Längsseite verlaufender Freirand gebildet, in dem keine Metallisierung vorhanden ist und der somit eine Isolierung der zweiten Hauptseite ermöglicht. Durch die auf der ersten Hauptseite aufgebrachte Metallisierungsschicht innerhalb des ersten Teilbereiches und der damit in elektrische Verbindung stehende Teilbereich der Längsseite ermöglicht das Ausbilden eines großflächigen Kontaktes auf der ersten Hauptseite, der über die auf dem Teilbereich der Längsseite aufgebrachte Metallisierungsschicht die wenigstens zwei ersten Elektroden elektrisch leitend kontaktiert.

Mit Vorteil ist dabei die zusammenhängende Metallisierungsschicht aufgesputtert. Der Sputterprozess kann derart erfolgen, dass mit Vorteil im Wesentlichen gleichzeitig sowohl die Metallisierungsschicht auf dem ersten Teilbereich der ersten Hauptseite als auch auf dem dem ersten Teilbereich benachbarten Teilbereich der Längsseite aufgebracht wird.

Ebenso erstreckt sich die Metallisierungsschicht auch auf einen Teilbereich auf der zweiten Längsseite, welche der ersten Längsseite gegenüberliegend angeordnet ist. Somit kann die Metallisierungsschicht sich auf Teilbereiche erstrecken, die beidseitig entlang der Längsseiten des piezoelektrischen Bauelementes angeordnet sind und die innerhalb des piezoelektrischen Bauelementes befindlichen wenigstens zwei ersten Elektroden elektrisch kontaktieren. In beiden Fällen weisen die Teilbereiche entlang der Längsseiten einen Abstand von der der zweiten Hauptseite zugewandten Seitenkante auf. Mit anderen Worten erstreckt sich die Metallisierungsschicht entlang der Längsseiten nicht vollständig über die gesamte Breite der Längsseite, sondern nur über einen Teilbereich. Dieser ist der ersten Hauptseite zugewandt. Ein Rand, beispielsweise mit einer Dicke im Bereich von 2 µm bis 14 µm, zwischen dem Teilbereich auf der Längsseite und der Seitenkante zwischen der Längsseite und der zweiten Hauptseite bleibt frei von einer Metallisierung. Dadurch ist gewährleistet, dass bei einer Montage des piezoelektrischen Bauelementes mit der zweiten Hauptseite auf einem Körper letzterer zu keinem elektrischen Kurzschluss mit den auf den Längsseiten befindlichen Metallisierungsschichten führt.

Darüber hinaus erstreckt sich die Metallisierungsschicht auch auf einen Teilbereich entlang einer dritten Längsseite. Beispielsweise kann die dritte Längsseite die Querseite des piezoelektrischen Bauelementes beziehungsweise des elektromechanischen Wandlers bilden.

Zur Verhinderung eines Kurzschlusses der wenigstens zwei Elektroden ist in einer Ausgestaltung vorgesehen, diese in einem Teilbereich des Wandlers außerhalb des Teilbereichs der ersten Längsseite mit einem Abstand zu einer Oberfläche der ersten Längsseite auszubilden. Dadurch haben die Elektroden in einem Teilbereich des Wandlers außerhalb der Metallisierungsschicht geringere Abmessungen und reichen insbesondere nicht bis zu der Oberfläche der Längsseite.

Auf diese Weise ist es möglich, eine zweite zusammenhängende Metallisierungsschicht auf einem zweiten Teilbereich der ersten Hauptseite des Wandlers und auf einem Teilbereich der Längsseite benachbart zu dem zweiten Teilbereich auszubilden. Die zweite Metallisierungsschicht auf dem zweiten Teilbereich ist von der Metallisierungsschicht auf dem ersten Teilbereich entsprechend beabstandet. In gleicher Weise sind auch die auf der Längsseite angeordneten Teilbereiche voneinander beabstandet. Zudem ist der Teilbereich der Längsseite mit der Metallisierungsschicht weiterhin zu der der zweiten Hauptseite zugewandten Seitenkante elektrisch isoliert, sodass ein möglicher Kurzschluss mit einem Montageelement angeordnet auf der zweiten Hauptseite vermieden wird.

Die zweite Metallisierungsschicht auf der ersten Hauptseite sowie der Längsseite dient dazu, die zumindest eine zweite Elektrode elektrisch leitend zu kontaktieren. Gleichzeitig ist die zweite Metallisierungsschicht von den wenigstens zwei ersten Elektroden elektrisch isoliert. Dies kann beispielsweise dadurch erfolgen, das die wenigstens zwei erste Elektroden im Teilbereich der Längsseite benachbart zum zweiten Teilbereich innerhalb des Wandlers sind und nicht an die längsseitige Oberfläche gelangen. Entsprechendes gilt auch für die zweite Elektrode im ersten Teilbereich und den dazu benachbarten Teilbereichen der Längsseite.

Auf diese Weise können zwei voneinander beabstandete und elektrisch isolierte Metallisierungsschichten auf der ersten Hauptseite ausgebildet werden, mit deren Hilfe die wenigstens zwei ersten sowie die zumindest eine zweite Elektrode elektrisch leitend kontaktiert werden. In einer Ausgestaltung weist die Metallisierungsschicht auf dem piezoelektrischen Bauelement eine Dicke von 0,3 µm bis 5 µm, und insbesondere eine Dicke von 0,5 µm bis 2 µm auf.

In einer Ausgestaltung umfasst das piezoelektrische Bauelement auf eine der ersten beziehungsweise zweiten Hauptseite eine Stufe. Diese kann beispielsweise dazu dienen, eine mechanische Kopplung mit einem Montageelement zu ermöglichen, auf das eine durch das piezoelektrische Bauelement hervorgerufene mechanische Schwingung übertragen werden soll. Zudem lassen sich auf der zweiten Hauptseite weitere mechanische Ausgestaltungen vornehmen, die aufgrund der Isolierung und des Abstandes zu der Metallisierungsschicht entlang der Längs- beziehungsweise ersten Hauptseite elektrisch isoliert sind.

In einer Ausgestaltung ist die Stufe auf der zweiten Hauptseite in einem Bereich angeordnet, der außerhalb einer Projektion des ersten beziehungsweise zweiten Teilbereichs auf der ersten Hauptseite liegt.

Die Metallisierungsschicht ist in dem Teilbereich entlang der Längsseite und der ersten Hauptseite aufgesputtert. Hierbei kann die Metallisierungsschicht auf den Teilbereichen der ersten und/oder zweiten Hauptseite beziehungsweise der Längsseiten im Wesentlichen gleichzeitig aufgebracht werden. Durch einen geeigneten Versatz des piezoelektrischen Bauelementes zur Sputterrichtung kann zudem gewährleistet sein, dass ein elektrischer Widerstand der Metallisierungsschicht entlang der Seitenkante zwischen der ersten Hauptseite und der Längsseite gering ist und keine Auswirkungen auf den Betrieb und die elektrische Kontaktierung der Elektroden besitzt.

In einem Verfahren zur Herstellung einer Kontaktierung gemäß Anspruch 11 wird in einem ersten Schritt ein piezoelektrisches Bauelement bereitgestellt, welches einen elektromechanischen Wandler umfasst. Dieser enthält wenigstens zwei erste Elektroden, zwischen denen eine zweite Elektrode angeordnet ist und die durch ein piezoelektrisches Material von den ersten Elektroden beabstandet ist. Der elektromechanische Wandler umfasst somit eine Reihe alternierend angeordneter Elektroden, die von einem piezoelektrischen Material umschlossen sind. Weiterhin weist der Wandler eine erste Hauptseite, eine der ersten Hauptseite gegenüberliegende zweite Hauptseite und eine erste Längsseite auf.

Erfindungsgemäß ist ein Aufsputtern einer zusammenhängenden Metallisierungsschicht zur Kontaktierung der Elektroden vorgesehen. Die Metallisierungsschicht wird auf einem Teilbereich der ersten Hauptseite und auf einem zu dem Teilbereich der ersten Hauptseite benachbarten Teilbereich der Längsseite aufgesputtert.

Dies erfolgt derart, dass die Metallisierungsschicht im Teilbereich entlang der Längsseite nicht vollständig über die Breite der Längsseite verläuft, sondern die Metallisierungsschicht einen Abstand zu einer der zweiten Hauptseite zugewandten Seitenkante aufweist. Mit anderen Worten wird entlang der Längsseite ein "Freirand" zwischen dem Teilbereich und der der zweiten Hauptseite zugewandten Seitenkante gebildet, welche frei von einer Metallisierungsschicht ist. Das Sputtermaterial gelangt also nicht in den Bereich des Freirandes während des Herstellungsverfahrens.

Die Metallisierungsschicht auf dem Teilbereich entlang der ersten Längsseite steht in elektrisch leitendem Kontakt mit der Metallisierungsschicht auf dem Teilbereich der ersten Hauptseite und kontaktiert zudem elektrisch leitend die wenigstens zwei ersten Elektroden des elektromechanischen Wandlers.

In einer weiteren Ausführungsform wird eine zweite zusammenhängende Metallisierungsschicht auf einem zweiten Teilbereich der ersten Hauptseite aufgesputtert, welche von dem ersten Teilbereich der ersten Hauptseite beabstandet ist. Somit sind der erste Teilbereich und der zweite Teilbereich voneinander elektrisch isoliert.

Eine Metallisierungsschicht wird zudem auch auf Teilbereichen der Längsseite benachbart zu dem zweiten Teilbereich der ersten Hauptseite aufgesputtert, sodass die Metallisierungsschicht entlang der Längsseite sowie auf dem Teilbereich der ersten Hauptseite miteinander elektrisch leitend in Verbindung steht. Die Metallisierungsschicht auf den zu dem zweiten Teilbereich benachbarten Teilbereich der ersten Längsseite kontaktiert die wenigstens eine zweite Elektrode. Zudem erstreckt sie sich nicht über die vollständige Breite der Längsseite, sondern es bleibt vielmehr ein nicht mit einer Metallisierungsschicht bedeckter Rand zwischen dem Teilbereich entlang der Längsseite und der der zweiten Hauptseite zugewandten Seitenkante übrig.

Im Weiteren wird die Erfindung anhand verschiedener Ausführungsformen unter Bezugnahme auf die Zeichnungen näher erläutert. Es zeigen:
- Figur 1A: eine Querschnittsdarstellung eines piezoelektrischen Bauelementes mit aufgesputteter Metallisierung gemäß einer ersten Ausführung,
- Figur 1B: eine Draufsicht auf das piezoelektrische Bauelement nach Figur 1A,
- Figur 2: ein piezoelektrisches Bauelement nach einer Ausführungsform nach dem Aufsputtern der Metallisierungsschicht in einer ersten perspektivischen Ansicht,
- Figur 3: das piezoelektrische Bauelement nach Figur 2 in einer zweiten perspektivischen Ansicht,
- Figur 4: ein piezoelektrisches Bauelement nach einer ersten Ausführungsform vor dem Aufsputtern der Metallisierungsschicht,
- Figur 5: eine Vorrichtung zur Durchführung eines Sputterprozesses für piezoelektrische Bauelemente nach dem vorgeschlagenen Verfahren.

Die in den folgenden Figuren dargestellten und erläuterten Ausführungsformen sind in ihren einzelnen Elementen nicht maßstabsgerecht gezeichnet. Insbesondere können einzelne Elemente zur näheren Verdeutlichung übertrieben groß beziehungsweise klein dargestellt werden. Einzelne nur in bestimmten Ausführungen angesprochene Aspekte, beispielsweise Schichtdicken, Abstände oder Materialien lassen sich ohne Weiteres auch auf die anderen Ausführungsformen übertragen. Wirkungs- und funktionsgleiche Bauelemente tragen die gleichen Bezugszeichen.

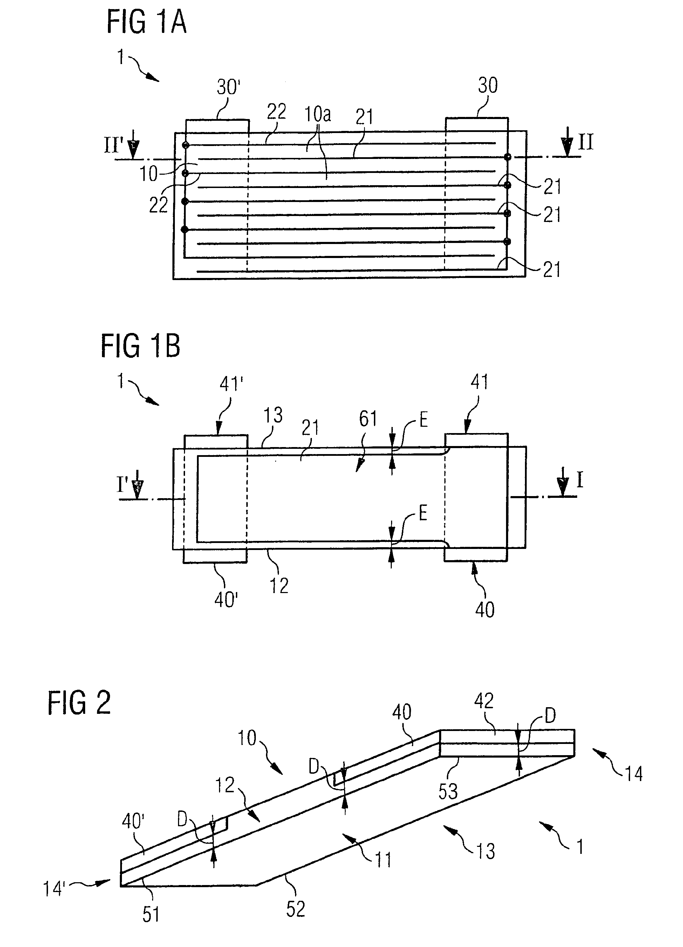

Figur 1A zeigt eine Querschnittsdarstellung eines piezoelektrischen Bauelementes mit einer aufgesputterten Metallisierungsschicht zur Kontaktierung einzelner Elektroden innerhalb des elektromechanischen Wandlers des Bauelementes.

Der elektromechanische Wandler 1 umfasst eine Vielzahl übereinander angeordneter erster Elektroden 21 und zweiter Elektroden 22. Diese sind beabstandet von einem piezoelektrischen Material 10 unter Bildung einer Schichtenfolge alternierend übereinander angeordnet. Die jeweils äußeren Elektroden sind zudem von einer weiteren Schicht umgeben, sodass die Elektroden vollständig im elektromechanischen Wandler umschlossen sind. Zur Kontaktierung der einzelnen Elektroden 21 und 22 sind Metallisierungsschichten auf den Seitenwänden und der ersten Hauptseite 10 aufgesputtert. Die Metallisierungsschicht 30 ist dabei auf der Seitenfläche so angeordnet, dass sie die einzelnen ersten Elektroden 21 elektrisch kontaktiert. Zu diesem Zweck sind die ersten Elektroden 21 in dem Teilbereich der Längsseite des piezoelektrischen Bauelementes, in dem sich die Metallisierungsschicht 30 befindet, an die Oberfläche der Längsseite geführt. Diese Struktur ist in Figur 2B dargestellt, der eine Draufsicht auf eine der Elektroden 21 zeigt.

In den Teilbereichen 40 beziehungsweise 41 der Längsseiten 12 und 13 des piezoelektrischen Bauelementes ist die Metallisierungsschicht aufgesputtert. In diesen Teilbereichen auf der Längsseite besitzt die Elektrode 21 eine Breite, welche im Wesentlichen der Breite des Wandlers 1 entspricht. Mit anderen Worten sind in den Teilbereichen 40 beziehungsweise 41 die Elektroden 21 an die längsseitige Oberfläche des Bauelementes geführt und stehen somit mit der Metallisierungsschicht in den Teilbereichen 40 und 41 in einer leitenden Verbindung.

Außerhalb der Teilbereiche 40 beziehungsweise 41 besitzen die Elektroden 21 eine leicht geringere Breite, sodass zwischen der längsseitigen Oberfläche des Bauelementes und der Elektrode ein geringfügiger Abstand E verbleibt. Die Elektroden 21 sind somit von einem isolierenden Material umgeben. Damit ist gewährleistet, dass die Elektroden 21 nicht die Oberfläche der Längsseite 12 beziehungsweise 13 des Bauelementes erreichen und so gegebenenfalls einen Kurzschluss verursachen. Insbesondere ist die Elektrode 21 in Teilbereiche 40' beziehungsweise 41' der Längsseiten 12 und 13 von der dortigen Metallisierungsschicht 30' elektrisch isoliert.

Die Elektroden 22 sind wiederum in den Teilbereichen 40' beziehungsweise 41' elektrisch leitend mit der dort aufgebrachten Metallisierungsschicht 30' verbunden. Ihre Form entspricht im Wesentlichen der Elektroden 21, nur sind sie vertauscht und ihre breite Seite ist an der längsseitigen Oberfläche in den Teilbereichen 40' und 41' und kontaktiert dort die Metallisierungsschicht.

Auf diese Weise kontaktiert die Metallisierungsschicht 30 auf der ersten Hauptseite des piezoelektrischen Bauelementes dargestellt durch die gestrichelte Linie die Elektroden 21. Entsprechend kontaktiert die Metallisierungsschicht 30' auf der ersten Hauptseite des Bauelementes über die Metallisierungsschicht auf den Teilbereichen 40' und 41' der Längsseite 12 und 13 die Elektroden 22 innerhalb des elektromechanischen Wandlers. Der Bereich 61 auf der ersten Hauptseite des piezoelektrischen Bauelementes ist frei und nicht mit einer aufgesputterten Metallisierungsschicht bedeckt.

Figur 2 zeigt eine perspektivische Darstellung des piezoelektrischen Bauelementes nach dem vorgeschlagenen Prinzip mit den aufgesputterten Metallisierungsschichten zur Kontaktierung der Elektroden innerhalb des elektromechanischen Wandlers. Das piezoelektrische Bauelement umfasst den elektromechanischen Wandler 1 mit einer ersten Hauptseite 10 und einer hier zu erkennenden zweiten Hauptseite 11. Die zweite Hauptseite 11 soll im vorliegenden Ausführungsbeispiel frei von einer Metallisierungsschicht sein, da sie als Montageseite des piezoelektrischen Bauelementes dient. Um einen Kurzschluss zu vermeiden, ist es daher notwendig, die Kontaktierung and die Elektroden innerhalb des elektromechanischen Wandlers 1 so zu gestalten, dass eine elektrisch leitende Verbindung zur zweiten Hauptseite 11 hin und damit Kurzschluss vermieden wird.

In diesem Ausführungsbeispiel ist entlang der Längsseite 12 in den Teilbereichen 41 und 41' eine Metallisierungsschicht aufgebracht. Diese kontaktiert Elektroden innerhalb des elektromechanischen Wandlers. Zudem sind die Teilbereiche 41 und 41' mit der darauf aufgesputterten Metallisierungsschicht von der Seitenkante 51 über den Abstand D beabstandet. Damit ist ein Freirand zwischen den Teilbereichen 41 und 41' zur Seitenkante 51 ausgebildet. Die Seitenkante 51 "verbindet" demzufolge die Längsseite 12 mit der zweiten Hauptseite 13.

Auf einer Querseite 14 des elektromechanischen Wandlers 1 ist ein weiterer Teilbereich 42 definiert, auf dem ebenfalls die Metallisierungsschicht aufgesputtert ist. Auch diese ist über einen Freirand mit dem Abstand D von der Seitenkante 53 entfernt. Durch den Freirand mit dem Abstand D, der beispielsweise in Bereich von 2 bis 14 µm liegt, ist eine ausreichende Isolierung der Metallisierungsschichten auf den Teilbereichen 41, 41' und 42 von der zweiten Hauptseite 11 gewährleistet.

Des Weiteren ist der elektromechanische Wandler 1 derart ausgeführt, dass im Bereich des Freirandes, das heißt im Bereich zwischen der zweiten Hauptseite mit den Seitenkanten 51, 52 und 53 zu den jeweiligen Teilbereichen 41, 41' und 42 keine weiteren Elektroden innerhalb des Wandlers angeordnet sind.

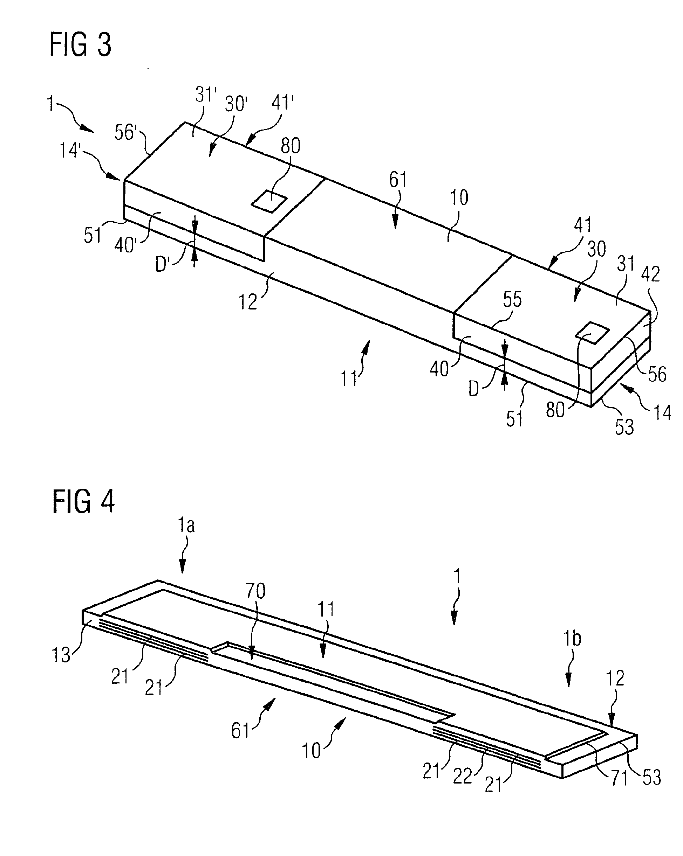

Figur 3 zeigt das piezoelektrische Bauelement gemäß Figur 2 von einer zweiten perspektivischen Ansicht. Die längsseitig angeordneten Teilbereiche 40, 40' und 42 sind über längsseitige Seitenkante 55 beziehungsweise die Querkante 56 elektrisch leitend mit der Metallisierungsschicht auf den Teilbereichen 31 und 31' der ersten Hauptseite 10 verbunden. Zudem sind auf der Metallisierungsschicht 30, 30' der beiden Teilbereiche 31 und 31' Kontaktierungen 80 aufgebracht. Mit Hilfe der Kontaktierungen 80 können Steuersignale den Elektroden innerhalb des elektromechanischen Wandlers 1 zugeführt werden. Die Verbindung an die Innenelektroden erfolgt somit an der Längsseite des Bauelementes über eine elektrisch leitende Verbindung mit Kontakten auf der Oberseite 10 des elektromechanischen Wandlers. Die Metallisierungsschicht über die Seitenkanten 55, 56 und 56' ist dabei derart ausgestaltet, dass sie keinen erhöhten elektrischen Widerstand aufweist.

Figur 4 zeigt eine weitere Ausführungsform eines piezoelektrischen Bauelementes in perspektivischer Darstellung vor dem Aufsputtern der Metallisierungsschicht. Bei dieser Ausführungsform ist auf der zweiten Hauptseite 11, der Unterseite, eine zusätzliche Stufe 70 eingebracht. Diese ist konstruktionsbedingt und dient für die spätere Befestigung an einem Motor, der durch das piezoelektrische Bauelement und den elektromechanischen Wandler 1 betrieben wird. In der Ausführung umfasst der elektromechanische Wandler zwei Teilbereiche 1a und 1b, die durch einen feldfreien und elektrodenfreien Bereich 61 voneinander beabstandet sind. In dem Teilbereich 61 ist auf der zweiten Hauptseite ebenfalls die Stufe 70 eingearbeitet. Daneben weist das Bauelement einen den elektromechanischen Wandler auf drei Seiten umgebenden Rand auf, sodass auf der zweiten Hauptseite 11 eine zusätzliche Stufe 71 beabstandet von der Seitenkante 53 vorliegt.

Die Teilbereiche 1a und 1b umfassen jeweils eine Vielzahl lateral alternierend übereinander angeordneter und durch piezoelektrisches Material beabstandete Elektroden 21 und 22. In der Ausgestaltung ist vorgesehen, dass die Elektroden 21 jeweils an die Oberfläche der Längsseite 13 des Bauelementes geführt sind. Im Gegensatz dazu sind die Elektroden 22 von der Oberfläche des elektromechanischen Wandlers isoliert und "floatend" innerhalb des elektromechanischen Wandlers 1 angeordnet. Eine Anregung des elektromechanischen Wandlers 1 zur Erzeugung einer Schwingung erfolgt somit über eine Zuführung eines Ansteuerpotentials an die Elektroden 21. Dadurch führt der elektromechanische Wandler 1 Schwingungen und insbesondere Biegeschwingungen aus.

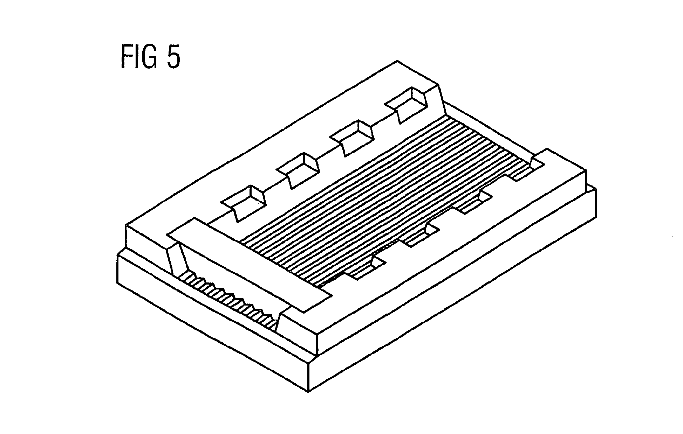

Zur Kontaktierung der Elektroden 21 wird nun der elektromechanische Wandler in eine Horde eingebracht, wobei die erste Hauptseite 10 in einem Winkel von zirka 25° zur Sputterrichtung angeordnet ist. Eine derartige Horde ist in Figur 5 dargestellt. Da die Stufe nicht mit einer Metallisierung versehen werden soll, wird der elektromechanische Wandler nach Figur 4 beim Sputtern so aufgehordet, dass die erste Hauptseite 10 nach oben in Sputterrichtung zeigt.

Anschließend wird die Metallisierungsschicht mit einer Dicke im Bereich von 0,5 µm bis 2 µm auf die Teilbereiche 1a beziehungsweise 1b auf der ersten Hauptseite 10 aufgesputtert. Aufgrund der in die Bauteiloberfläche eingearbeiteten Stufe 70 wird das Bauteil zur Vermeidung von Kurzschlüssen im montierten Zustand beim Sputtern so aufgehordet, dass die erste Hauptseite 10 nach oben zeigt. Ein eventuell beim Sputtern entstehender Überlapp auf der zweiten Hauptseite 11, der Montageseite des Bauteils, kann auf diese Weise neutralisiert werden. Die Metallisierung über die Längskante hinweg erfolgt dabei über die in der Figur 5 dargestellte Sputterhorde.

### Bezugszeichenliste

- 1: elektromechanischer Wandler
- 10a: piezoelektrisches Material
- 10: erste Hauptseite
- 11: zweite Hauptseite
- 12, 13: Längsseite
- 14: Querseite
- 21, 22: Elektroden
- 30, 30': Metallisierungsschicht
- 31, 31': erster Teilbereich
- 40, 40', 42: zweiter Teilbereich
- 51, 52, 53: Seitenkante
- D, E: Abstand

## Patentansprüche

1. Piezoelektrisches Bauelement, umfassend:
- einen elektromechanischen Wandler (1) umfassend wenigstens zwei erste Elektroden (21) und zumindest eine zweite Elektrode (22), die zwischen den wenigstens zwei ersten Elektroden (21) angeordnet und durch ein piezoelektrisches Material (10a) von ihnen beabstandet ist,
- der Wandler (1) weiter aufweisend eine erste Hauptseite (10), eine der ersten Hauptseite (10) gegenüberliegende zweite Hauptseite (11) und eine erste Längsseite (12);
- eine erste zusammenhängende Metallisierungsschicht (30) auf einem ersten Teilbereich (31) der ersten Hauptseite (10) und auf einem dem ersten Teilbereich (31) der ersten Hauptseite (10) benachbarten Teilbereich (40) der ersten Längsseite (12), wobei der Teilbereich (40) der ersten Längsseite (12) einen ausreichend isolierenden Abstand (D) von einer der zweiten Hauptseite (11) zugewandten Seitenkante (51) aufweist und die wenigstens zwei ersten Elektroden (21) elektrisch leitend kontaktiert
**gekennzeichnet durch**
- eine zweite Längsseite (13) der ersten Längsseite (12) gegenüberliegend angeordnet, die einen dem ersten Teilbereich (31) der ersten Hauptseite (10) benachbarten Teilbereich (41) umfasst, auf dem die Metallisierungsschicht aufgesputtert ist, welche die wenigstens zwei ersten Elektroden (21) elektrisch leitend kontaktiert, wobei der Teilbereich (41) der zweiten Längsseite (13) einen ausreichend isolierenden Abstand (D) von der der zweiten Hauptseite (11) zugewandten Seitenkante (52) aufweist;
- eine dritte Längsseite (14), die einen zu dem ersten Teilbereich (31) der ersten Hauptseite (10) benachbarten Teilbereich (42) aufweist, auf dem die Metallisierungsschicht (30) angeordnet ist, welche die wenigstens zwei ersten Elektroden (21) elektrisch leitend kontaktiert, wobei der Teilbereich (42) der dritten Längsseite (14) einen ausreichend isolierenden Abstand (D) von einer der zweiten Hauptseite (11) zugewandten Seitenkante (53) aufweist.

2. Das piezoelektrische Bauelement nach Anspruch 1, bei dem die dritte Längsseite (14) die Querseite des Wandlers (1) bildet.

3. Das piezoelektrische Bauelement nach einem der Ansprüche 1 bis 2, bei dem die wenigstens zwei ersten Elektroden (21) in einem Teilbereich (61) des Wandlers (1) außerhalb des ersten Teilbereichs der ersten Längsseite (12) einen Abstand (E) zu einer Oberfläche der ersten Längsseite (12) aufweisen.

4. Das piezoelektrische Bauelement nach einem der Ansprüche 1 bis 3, weiter umfassend:
- eine zweite zusammenhängende Metallisierungsschicht (30_{'}) auf einem zweiten Teilbereich (31') der ersten Hauptseite (10) des Wandlers (1), der von dem ersten Teilbereich (31) beabstandet ist und auf einem zu dem zweiten Teilbereich (31') benachbarten Teilbereich (40', 14') der ersten und/oder dritten Längsseite (12, 14), wobei der benachbarte Teilbereich (40', 14') einen Abstand (D) zu der der zweiten Hauptseite (11) zugewandten Seitenkante (51, 53)) aufweist und die zweite Metallisierungsschicht (30') die zumindest eine zweite Elektrode (22) elektrisch leitend kontaktiert.

5. Das piezoelektrische Bauelement nach einem der Ansprüche 1 bis 4, bei dem die Teilbereiche (40, 41, 42) der ersten, zweiten und/oder dritten Längsseite (12, 13, 14) von einer der zweiten Hauptseite (11) zugewandten Seitenkante (51, 52 , 53) einen Abstand (D) von 2 µm bis 25 µm, insbesondere einen Abstand (D) im Bereich von 2 µm bis 14 µm aufweisen

6. Das piezoelektrische Bauelement nach einem der Ansprüche 1 bis 4, bei dem die Metallisierungsschicht (30, 30') eine Dicke von 0,3 µm bis 5 µm, insbesondere eine Dicke von 0,5 µm bis 2 µm aufweist.

7. Das piezoelektrische Bauelement nach einem der Ansprüche 1 bis 5, bei dem das Bauelement auf einer der ersten und zweiten Hauptseite eine Stufe (70) aufweist.

8. Das piezoelektrische Bauelement nach Anspruch 7, bei dem die Stufe (70) in einem Teilbereich (61) des Wandlers (1) außerhalb des ersten und/oder zweiten Teilbereichs (30, 31') angeordnet ist.

9. Das piezoelektrische Bauelement nach einem der Ansprüche 1 bis 8, bei dem die Metallisierungsschicht in den Teilbereichen (31, 31', 40, 40', 41, 41') aufgesputtert ist.

10. Das piezoelektrische Bauelement nach einem der Ansprüche 1 bis 9, bei dem die Metallisierungsschicht auf den Teilbereichen der ersten Hauptseite (10) und der Längsseite (12, 13, 14) im Wesentlichen gleichzeitig aufgebracht ist.

11. Verfahren zur Herstellung eines elektrischen Kontaktes, umfassend:
- Bereitstellen eines piezoelektrischen Bauelementes mit einem elektromechanischen Wandler (1) umfassend wenigstens zwei erste Elektroden (21) und zumindest eine zweite Elektrode (22), die zwischen den wenigstens zwei ersten Elektroden (21) angeordnet und durch ein piezoelektrisches Material (10) von ihnen beabstandet ist, der Wandler (1) weiter umfassend eine erste Hauptseite (10), eine der ersten Hauptseite (10) gegenüberliegende zweite Hauptseite (11) und eine erste Längsseite (12);
- Aufsputtern einer zusammenhängenden Metallisierungsschicht (30) auf einen Teilbereich (31) der ersten Hauptseite (10) und auf einen zu dem Teilbereich (31) der ersten Hauptseite (10) benachbarten Teilbereich (40) entlang der ersten Längsseite (12), so dass der Teilbereich (40) entlang der ersten Längsseite (12) einen Abstand (D) zu einer der zweiten Hauptseite (11) zugewandten Seitenkante (51) aufweist und die Metallisierungsschicht (30) im Teilbereich (40) der ersten Längsseite (12) elektrisch leitend die wenigstens zwei ersten Elektroden (21) kontaktiert;
- **dadurch gekennzeichnet, dass** die zusammenhängende Metallisierungsschicht (30) über einen Teilbereich (41) einer der ersten Längeseite (12) gegenüberliegende zweiten Längsseite (13) gesputtert wird, so dass der Teilbereich (41) der zweiten Längsseite (13) einen Abstand (D) zu der der zweiten Hauptseite (11) zugewandten Seitenkante (52) aufweist und die Metallisierungsschicht (30) die wenigstens zwei ersten Elektroden (21) kontaktiert und die zusammenhängende Metallisierungsschicht (30) über eine dritte Längsseite (14), welche die Querseite des Wandlers bildet gesputtert wird, so dass ein Teilbereich (42) der dritten Längsseite (14) einen ausreichend isolierenden Abstand (D) von einer der zweiten Hauptseite (11) zugewandten Seitenkante (53) aufweist und die wenigstens zwei ersten Elektroden (21) elektrisch leitend kontaktiert.

12. Verfahren nach Anspruch 11, bei dem der Abstand im Bereich zwischen 2 µm und 14 µm liegt.

13. Verfahren nach einem der Ansprüche 11 bis 12, bei dem die Metallisierungsschicht (30) über eine Seitenkante (55) zwischen dem Teilbereich (31) der ersten Hauptseite (10) und dem Teilbereich (40) der ersten Längsseite (12) verläuft.

14. Verfahren nach einem der Ansprüche 11 bis 12, bei dem ein Kontakt auf der Metallisierungsschicht (30, 30') auf dem Teilbereich (31) der ersten Hauptseite (10) aufgebracht wird.

## Claims

1. Piezoelectric component, comprising:
- an electromechanical transducer (1) comprising at least two first electrodes (21) and at least one second electrode (22), which is arranged between the at least two first electrodes (21) and is kept at a distance from them by a piezoelectric material (10a),
- the transducer (1) also having a first main side (10), a second main side (11), opposite from the first main side (10), and a first longitudinal side (12);
- a first contiguous metallization layer (30) on a first partial region (31) of the first main side (10) and on a partial region (40) of the first longitudinal side (12) that is adjacent to the first partial region (31) of the first main side (10), the partial region (40) of the first longitudinal side (12) being at a sufficiently insulating distance (D) from a side edge (51) facing the second main side (11) and contacting the at least two first electrodes (21) in an electrically conducting manner,
**characterized by**
- a second longitudinal side (13), arranged opposite from the first longitudinal side (12), which comprises a partial region (41) which is adjacent to the first partial region (31) of the first main side (10) and on which the metallization layer that contacts the at least two first electrodes (21) in an electrically conducting manner is sputtered, the partial regional (41) of the second longitudinal side (13) being at a sufficiently insulating distance (D) from the side edge (52) facing the second main side (11);
- a third longitudinal side (14), which has a partial region (42) which is adjacent to the first partial region (31) of the first main side (10) and on which the metallization layer (30) that contacts the at least two first electrodes (21) in an electrically conducting manner is arranged, the partial region (42) of the third longitudinal side (14) being at a sufficiently insulating distance (D) from a side edge (53) facing the second main side (11).

2. The piezoelectric component according to Claim 1, in which the third longitudinal side (14) forms the transverse side of the transducer (1).

3. The piezoelectric component according to either of Claims 1 and 2, in which the at least two first electrodes (21) in a partial region (61) of the transducer (1) outside the first partial region of the first longitudinal side (12) are at a distance (E) from a surface of the first longitudinal side (12).

4. The piezoelectric component according to one of Claims 1 to 3, further comprising:
- a second contiguous metallization layer (30') on a second partial region (31') of the first main side (10) of the transducer (1) that is at a distance from the first partial region (31) and on a partial region (40', 14') of the first and/or third longitudinal side (12, 14) that is adjacent to the second partial region (31'), the adjacent partial region (40', 14') being at a distance (D) from the side edge (51, 53) facing the second main side (11) and the second metallization layer (30') contacting the at least one second electrode (22) in an electrically conducting manner.

5. The piezoelectric component according to one of Claims 1 to 4, in which the partial regions (40, 41, 42) of the first, second and/or third longitudinal side(s) (12, 13, 14) are at a distance (D) from a side edge (51, 52, 53) facing the second main side (11) of from 2 µm to 25 µm, in particular a distance (D) in the range from 2 µm to 14 µm.

6. The piezoelectric component according to one of Claims 1 to 4, in which the metallization layer (30, 30') has a thickness of from 0.3 µm to 5 µm, in particular a thickness of from 0.5 µm to 2 µm.

7. The piezoelectric component according to one of Claims 1 to 5, in which the component has a step (70) on the first or second main side.

8. The piezoelectric component according to Claim 7, in which the step (70) is arranged in a partial region (61) of the transducer (1) outside the first and/or second partial region(s) (30, 31').

9. The piezoelectric component according to one of Claims 1 to 8, in which the metallization layer is sputtered on in the partial regions (31, 31', 40, 40', 41, 41').

10. The piezoelectric component according to one of Claims 1 to 9, in which the metallization layer is applied substantially simultaneously on the partial regions of the first main side (10) and the longitudinal side (12, 13, 14).

11. Method for producing an electrical contact, comprising:
- providing a piezoelectric component, with an electromechanical transducer (1) comprising at least two first electrodes (21) and at least one second electrode (22), which is arranged between the at least two first electrodes (21) and is kept apart from them by a piezoelectric material (10a), the transducer (1) further comprising a first main side (10), a second main side (11), opposite from the first main side (10), and a first longitudinal side (12);
- sputtering a contiguous metallization layer (30) onto a partial region (31) of the first main side (10) and onto a partial region (40) along the first longitudinal side (12) adjacent to the partial region (31) of the first main side (10), so that the partial region (40) along the first longitudinal side (12) is at a distance (D) from a side edge (51) facing the second main side (11) and the metallization layer (30) in the partial region (40) of the first longitudinal side (12) contacts the at least two first electrodes (21) in an electrically conducting manner;
**characterized in that**
- the contiguous metallization layer (30) is sputtered over a partial region (41) of a second longitudinal side (13), opposite from the first longitudinal side (12), so that the partial region (41) of the second longitudinal side (13) is at a distance (D) from the side edge (52) facing the second main side (11) and the metallization layer (30) contacts the at least two first electrodes (21) and the contiguous metallization layer (30) is sputtered over a third longitudinal side (14) which forms the transverse side of the transducer, so that a partial region (42) of the third longitudinal side (14) is at a sufficiently insulating distance (D) from a side edge (53) facing the second main side (11), and contacts the at least two first electrodes (21) in an electrically conducting manner.

12. Method according to Claim 11, in which the distance lies in the range between 2 µm and 14 µm.

13. Method according to either of Claims 11 and 12, in which the metallization layer (30) runs over a side edge (55) between the partial region (31) of the first main side (10) and the partial region (40) of the first longitudinal side (12).

14. Method according to either of Claims 11 and 12, in which a contact on the metallization layer (30, 30') is applied to the partial region (31) of the first main side (10).

## Revendications

1. Composant piézoélectrique comprenant:
- un convertisseur électromécanique (1) comprenant au moins deux premières électrodes (21) et au moins une deuxième électrode (22) qui est disposée entre les au moins deux premières électrodes (21) et qui est espacée de celles-ci par un matériau piézoélectrique (10a),
- le convertisseur (1) présentant en outre un premier côté principal (10), un deuxième côté principal (11) à l'opposé du premier côté principal (10) et un premier côté longitudinal (12);
- une première couche de métallisation (30) cohérente sur une première zone partielle (31) du premier côté principal (10) et sur une zone partielle (40) du premier côté longitudinal (12), voisine de la première zone partielle (31) du premier côté principal (10), la zone partielle (40) du premier côté longitudinal (12) présentant un écart (D) suffisamment isolant par rapport au bord latéral (51) qui fait face au deuxième côté principal (11) et étant en contact électriquement conducteur avec les au moins deux premières électrodes (21),
**caractérisé par**
- un deuxième côté longitudinal (13) disposé à l'opposé du premier côté longitudinal (12), lequel comprend une zone partielle (41) voisine de la première zone partielle (31) du premier côté principal (10), sur laquelle est pulvérisée la couche de métallisation qui est en contact électriquement conducteur avec les au moins deux premières électrodes (21), la zone partielle (41) du deuxième côté longitudinal (13) présentant un écart (D) suffisamment isolant par rapport au bord latéral (52) qui fait face au deuxième côté principal (11);
- un troisième côté longitudinal (14) qui présente une zone partielle (42) voisine de la première zone partielle (31) du premier côté principal (10), sur laquelle est disposée la couche de métallisation (30) qui est en contact électriquement conducteur avec les au moins deux premières électrodes (21), la zone partielle (42) du troisième côté longitudinal (14) présentant un écart (D) suffisamment isolant par rapport au bord latéral (53) qui fait face au deuxième côté principal (11).

2. Composant piézoélectrique selon la revendication 1, dans lequel le troisième côté longitudinal (14) forme le côté transversal du convertisseur (1).

3. Composant piézoélectrique selon l'une des revendications 1 à 2, dans lequel les au moins deux premières électrodes (21) présentent dans une zone partielle (61) du convertisseur (1), à l'extérieur de la première zone partielle du premier côté longitudinal (12), un écart (E) par rapport à une surface du premier côté longitudinal (12).

4. Composant piézoélectrique selon l'une des revendications 1 à 3, comprenant en outre:
- une deuxième couche de métallisation (30') cohérente sur une deuxième zone partielle (31') du premier côté principal (10) du convertisseur (1), laquelle est espacée de la première zone partielle (31) et se trouve sur une zone partielle (40', 14') du premier et/ou troisième côté longitudinal (12, 14) qui est voisine de la deuxième zone partielle (31'), la zone partielle (40', 14') voisine présentant un écart (D) par rapport au bord latéral (51, 53) qui fait face au deuxième côté principal (11) et la deuxième couche de métallisation (30') étant en contact électriquement conducteur avec l'au moins une deuxième électrode (22).

5. Composant piézoélectrique selon l'une des revendications 1 à 4, dans lequel les zones partielles (40, 41, 42) du premier, du deuxième et/ou du troisième côté longitudinal (12, 13, 14) présentent par rapport à un bord latéral (51, 52, 53) qui fait face au deuxième côté principal (11) un écart (D) de 2 µm à 25 µm, notamment un écart (D) dans la plage de 2 µm à 14 µm.

6. Composant piézoélectrique selon l'une des revendications 1 à 4, dans lequel la couche de métallisation (30, 30') présente une épaisseur de 0,3 µm à 5 µm, notamment une épaisseur de 0,5 µm à 2 µm.

7. Composant piézoélectrique selon l'une des revendications 1 à 5, dans lequel le composant présente un palier (70) sur le premier ou le deuxième côté principal.

8. Composant piézoélectrique selon la revendication 7, dans lequel le palier (70) est disposé dans une zone partielle (61) du convertisseur (1) en dehors de la première et/ou de la deuxième zone partielle (30, 31').

9. Composant piézoélectrique selon l'une des revendications 1 à 8, dans lequel la couche de métallisation est pulvérisée dans les zones partielles (31, 31', 40, 40', 41, 41').

10. Composant piézoélectrique selon l'une des revendications 1 à 9, dans lequel la couche de métallisation est appliquée pour l'essentiel simultanément sur les zones partielles du premier côté principal (10) et du côté longitudinal (12, 13, 14).

11. Procédé de fabrication d'un contact électrique comprenant:
- la mise à disposition d'un composant piézoélectrique muni d'un convertisseur électromécanique (1) comprenant au moins deux premières électrodes (21) et au moins une deuxième électrode (22) qui est disposée entre les au moins deux premières électrodes (21) et qui est espacée de celles-ci par un matériau piézoélectrique (10a), le convertisseur (1) présentant en outre un premier côté principal (10), un deuxième côté principal (11) à l'opposé du premier côté principal (10) et un premier côté longitudinal (12);
- la pulvérisation d'une couche de métallisation (30) cohérente sur une zone partielle (31) du premier côté principal (10) et sur une zone partielle (40) le long du premier côté longitudinal (12), voisine de la première zone partielle (31) du premier côté principal (10), de sorte que la zone partielle (40) le long du premier côté longitudinal (12) présente un écart (D) par rapport à un bord latéral (51) qui fait face au deuxième côté principal (11) et la couche de métallisation (30) est en contact électriquement conducteur avec les au moins deux premières électrodes (21) dans la zone partielle (40) du premier côté longitudinal (12);
**caractérisé en ce que**
- la couche de métallisation (30) cohérente est pulvérisée sur une zone partielle (41) d'un deuxième côté longitudinal (13) à l'opposé du premier côté longitudinal (12), de sorte que la zone partielle (41) du deuxième côté longitudinal (13) présente un écart (D) par rapport au bord latéral (52) qui fait face au deuxième côté principal (11) et la couche de métallisation (30) est en contact avec les au moins deux premières électrodes (21) et la couche de métallisation (30) cohérente est pulvérisée sur un troisième côté longitudinal (14) qui forme le côté transversal du convertisseur, de sorte qu'une zone partielle (42) du troisième côté longitudinal (14) présente un écart (D) suffisamment isolant par rapport à un bord latéral (53) qui fait face au deuxième côté principal (11) et est en contact électriquement conducteur avec les au moins deux premières électrodes (21).

12. Procédé selon la revendication 11, dans lequel l'écart est compris dans la plage de 2 µm à 14 µm.

13. Procédé selon l'une des revendications 11 et 12, dans lequel la couche de métallisation (30) s'étend sur un bord latéral (55) entre la zone partielle (31) du premier côté principal (10) et la zone partielle (40) du premier côté longitudinal (12).

14. Procédé selon l'une des revendications 11 et 12, dans lequel un contact est appliqué sur la couche de métallisation (30, 30') sur la zone partielle (31) du premier côté principal (10).
